# EUROPEAN PATENT APPLICATION

(11) **EP 4 163 719 A1**
(43) Date of publication of application: **12.04.2023**
(21) Application number: 21817765.7
(22) Date of filing: 20.05.2021
(51) Int. Cl.: G03F 1/64, G03F 7/20

(54) **PELLICLE FRAME, PELLICLE, PELLICLE-EQUIPPED EXPOSURE ORIGINAL PLATE, EXPOSURE METHOD, METHOD FOR MANUFACTURING SEMICONDUCTOR, AND METHOD FOR MANUFACTURING LIQUID CRYSTAL DISPLAY BOARD**

(30) Priority: 04.06.2020 JP 2020097943
(71) Applicant: SHIN-ETSU CHEMICAL CO., LTD., Tokyo 1000005 (JP)
(72) Inventor: YANASE, Yu, Annaka-shi, Gunma 379-0127 (JP)
(74) Representative: Held, Stephan
(86) International application number: PCT/JP2021/019219
(87) International publication number: WO 2021/246187

(57) **Abstract**

Provided are: a frame-shaped pellicle frame 1 having a pellicle frame main body 1a and an insulation layer 1b covering the pellicle frame main body; a pellicle comprising a pellicle film that is provided on the pellicle frame 1 and a top end surface 13 of the pellicle frame with an adhesive or pressure-sensitive adhesive therebetween; a pellicle-equipped exposure original plate; an exposure method; a method for manufacturing a semiconductor; and a method for manufacturing a liquid crystal display board. The pellicle frame can reduce falling of a foreign matter adhered to the surface thereof.

## Description

### TECHNICAL FIELD

This invention relates to a pellicle which is mounted on a lithographic photomask as a dust cover, pellicle frame, pellicle-mounted exposure original, exposure method, method for manufacturing semiconductor device, and method for manufacturing liquid crystal (LC) display panel.

### BACKGROUND ART

In recent years, the miniaturization of the design rule of LSIs is in progress to the sub-quarter-micron order. Concomitantly, the exposure light source becomes shorter in wavelength. Specifically, the exposure light source makes a transition from g-line (436 nm) and i-line (365 nm) of mercury lamps to KrF excimer laser (248 nm) and ArF excimer laser (193 nm). A further study is made on the EUV lithography using extreme ultraviolet (EUV) radiation of main wavelength 13.5 nm.

In the manufacture of semiconductor devices such as LSIs and VLSIs or LC display panels, semiconductor wafers or LC matrices are exposed to light to print patterns. If dust is deposited on lithographic photomasks and reticles (collectively referred to as "exposure original," hereinafter) used herein, the dust absorbs or deflects light, raising such problems that the transferred pattern can be deformed or roughened at the edge, and the background be stained black, detracting from size, quality, appearance and other factors.

Although these operations are generally performed in a cleanroom, it is yet difficult to always maintain the exposure original clean. It is thus a common practice to attach a pellicle to the surface of the exposure original as a dust cover before exposure. In this situation, contaminants do not directly deposit on the surface of the exposure original, but on the pellicle. Now that a focus is set on the pattern of the exposure original during lithographic transfer, the contaminants on the pellicle do not participate in the transfer.

The pellicle is basically constructed such that a pellicle membrane having a high transmittance to radiation used in the exposure is extended on the upper end surface of a pellicle frame made of aluminum or titanium, and a gas-tight gasket is formed on the lower end surface of the pellicle frame. A pressure-sensitive adhesive (PSA) layer is generally used as the gas-tight gasket. A protective sheet is attached to the PSA layer for protection purpose. While the pellicle membrane is made of nitrocellulose, cellulose acetate, and fluoro-polymers which are fully transmissive to radiation used in the exposure such as g-line (436 nm) or i-line (365 nm) of mercury lamps, KrF excimer laser (248 nm) or ArF excimer laser (193 nm), a very thin silicon membrane or carbon membrane is investigated as the pellicle membrane for the EUV lithography.

In particular, since the EUV lithography is performed under high vacuum, the pellicle for EUV lithography is exposed to pressure changes from atmospheric to vacuum and vice versa. In this course, an air flow occurs through a ventilating port provided in the pellicle frame. Since an internal air flow, which is not found in the ArF pellicle, occurs in the EUV pellicle, there is a high risk that contaminants deposited on the pellicle frame surface fall on the exposure original. Therefore, the EUV pellicle needs stricter contaminant inspection than the ArF pellicle.

To prevent contaminants from falling off the pellicle frame, Patent Document 1 proposes to coat the inner surface of the pellicle frame with a pressure-sensitive adhesive layer. However, this proposal of preventing contaminants from falling off the pellicle frame inner surface is insufficient when air migration occurs both inside and outside the pellicle as in the EUV pellicle.

### PRIOR ART DOCUMENTS

### PATENT DOCUMENTS

Patent Document 1: JP-A S60-57841

### SUMMARY OF INVENTION

### TECHNICAL PROBLEM

An object of the invention, which has been made under the above-mentioned circumstances, is to provide a pellicle frame which is effective for substantially preventing contaminants deposited on the surface of the frame from falling off, pellicle, pellicle-mounted exposure original, exposure method, method for manufacturing semiconductor device, and method for manufacturing LC display panel.

### SOLUTION TO PROBLEM

Making extensive investigations to attain the above object, the inventor has found that by forming an insulating layer on the surface of a pellicle frame main body, preferably an insulating layer made of a material having a volume resistivity of at least 10⁸ Ω·m, it becomes possible that when contaminants come in contact with the insulating layer, the electric charge of the insulating layer maintains the contaminants deposited on the frame surface as such and prevents the contaminants deposited on the frame surface from falling off even when air migration occurs inside the pellicle. The insulating layer is particularly useful in pellicles for the EUV lithography. The invention is predicated on this finding.

Accordingly, the invention provides a pellicle frame, pellicle, pellicle-mounted exposure original, exposure method, method for manufacturing semiconductor device, and method for manufacturing LC display panel, as defined below.
1. A pellicle frame in a frame shape comprising a pellicle frame main body and an insulating layer covering the pellicle frame main body.
2. The pellicle frame of 1 wherein the insulating layer has a volume resistivity of at least 10⁸ Q m.
3. The pellicle frame of 1 or 2 wherein the pellicle frame main body is made of titanium or a titanium alloy.
4. The pellicle frame of 1 or 2 wherein the insulating layer is non-pressure-sensitive adhesive.
5. The pellicle frame of 1 or 2 wherein the insulating layer is formed of an inorganic material.
6. The pellicle frame of 1 or 2 wherein the insulating layer is formed on the entire surface of the pellicle frame main body.
7. The pellicle frame of 1 or 2 wherein the pellicle frame is made of a metal having a coefficient of linear expansion of up to 10×10⁻⁶ (1/K).
8. The pellicle frame of 1 or 2 wherein the pellicle frame has a thickness of less than 2.5 mm.
9. A pellicle comprising the pellicle frame of 1 and a pellicle membrane which is disposed on the upper end surface of the pellicle frame via an adhesive or pressure-sensitive adhesive.
10. The pellicle of 9 which is used for exposure under vacuum or reduced pressure.
11. The pellicle of 9 or 10 which is used in EUV lithography.
12. The pellicle of 9 or 10 which is not equipped with a filter.
13. The pellicle of 9 or 10 which is used in exposure at a scanning speed of at least 300 mm/sec.
14. The pellicle of 9 or 10, having a height of up to 2.5 mm.
15. The pellicle of 9 or 10 wherein the pellicle membrane is a pellicle membrane held by a rim.
16. A pellicle-mounted exposure original comprising an exposure original and the pellicle of 9 mounted thereon.
17. The pellicle-mounted exposure original of 16 wherein the exposure original is an exposure original for EUV lithography.
18. The pellicle-mounted exposure original of 16 which is a pellicle-mounted exposure original for use in EUV lithography.
19. An exposure method comprising the step of exposure through the pellicle-mounted exposure original of 16.
20. A method for manufacturing a semiconductor device comprising the step of exposing a substrate to radiation through the pellicle-mounted exposure original of 16 under vacuum or reduced pressure.
21. A method for manufacturing a liquid crystal display panel comprising the step of exposing a substrate to radiation through the pellicle-mounted exposure original of 16 under vacuum or reduced pressure.
22. A method for manufacturing a semiconductor device comprising the step of exposing a substrate to EUV through the pellicle-mounted exposure original of 16.
23. A method for manufacturing a liquid crystal display panel comprising the step of exposing a substrate to EUV through the pellicle-mounted exposure original of 16.
24. A method for manufacturing a semiconductor device comprising the step of exposing a substrate to radiation through the pellicle-mounted exposure original of 16 at a scanning speed of at least 300 mm/sec.
25. A method for manufacturing a liquid crystal display panel comprising the step of exposing a substrate to radiation through the pellicle-mounted exposure original of 16 at a scanning speed of at least 300 mm/sec.

### ADVANTAGEOUS EFFECTS OF INVENTION

According to the invention, a pellicle frame and a pellicle substantially prevent the contaminants deposited on the pellicle frame surface from falling off and are particularly useful in pellicles for the EUV lithography. The pellicle is useful in a semiconductor device or LC display panel manufacturing method involving the step of exposing a substrate to radiation through a pellicle-mounted exposure original.

### BRIEF DESCRIPTION OF DRAWINGS

[FIG. 1] FIG. 1(A) is a perspective view of a pellicle frame according to one embodiment of the invention, and FIG. 1(B) is a cross-sectional view taken along lines E-E'.
[FIG. 2] FIG. 2 is a schematic cross-sectional view of the inventive pellicle mounted on a photomask.

### DESCRIPTION OF EMBODIMENTS

Now the invention is described in detail.

The invention provides a pellicle frame in a frame shape having an upper end surface adapted to bear a pellicle membrane and a lower end surface adapted to face a photomask.

As long as the pellicle frame is in a frame shape, its shape corresponds to the shape of a photomask on which a pellicle is mounted. In general, it is a four-sided (rectangular or square) frame. The shape of corners or edges of the pellicle frame may be an angular or pointed shape as primarily machined or another shape, typically curvilinear shape as homed or chamfered such as by rounding or chamfering.

The pellicle frame further has a surface (referred to as upper end surface) on which a pellicle membrane is to be extended and a surface (referred to as lower end surface) adapted to face a photomask when the pellicle is mounted on the photomask.

In general, the pellicle frame is provided on its upper end surface with a pellicle membrane via an adhesive and on its lower end surface with a PSA layer for mounting the pellicle on the photomask although the invention is not limited thereto.

The size of the pellicle frame is not particularly limited. Since the height of the pellicle for the EUV lithography is limited to 2.5 mm or less, the thickness of the pellicle frame for the EUV lithography is preferably smaller than the height, i.e., less than 2.5 mm. The thickness of the pellicle frame for the EUV lithography is more preferably equal to or less than 1.5 mm when the thicknesses of a pellicle membrane and photomask PSA are taken into account. The lower limit of thickness of the pellicle frame is preferably 1.0 mm or more.

The invention provides a pellicle frame comprising a pellicle frame main body and an insulating layer with which the pellicle frame main body is covered.

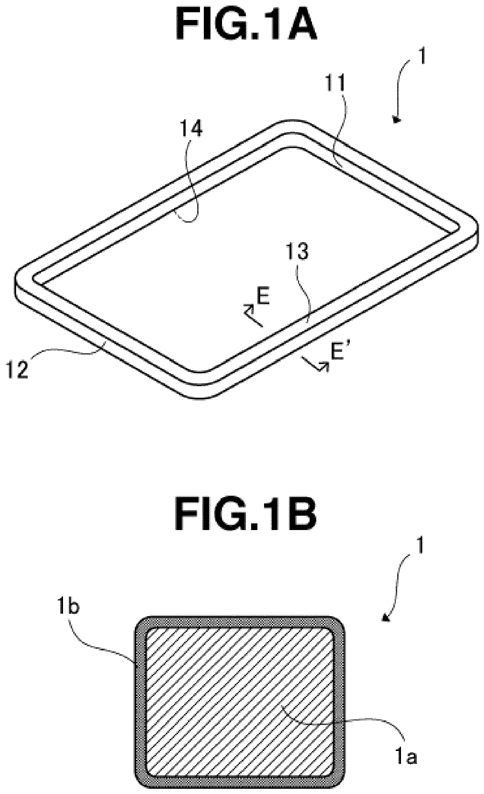

FIG. 1(A) illustrates a pellicle frame 1 according to one embodiment of the invention, the pellicle frame having an inside surface 11, an outside surface 12, an upper end surface 13, and a low end surface 14. As best shown in FIG. 1(B), the pellicle frame 1 comprises a pellicle frame main body or base 1a in a frame shape and an insulating layer 1b with which the pellicle frame main body is covered. Though not shown, the pellicle frame 1 may be provided with one or more notches or penetrations which are open at the upper or lower end. Also, the long side of the pellicle frame 1 may be provided with a jig hole which is utilized during dismounting of the pellicle from the photomask, though not shown in FIG. 1.

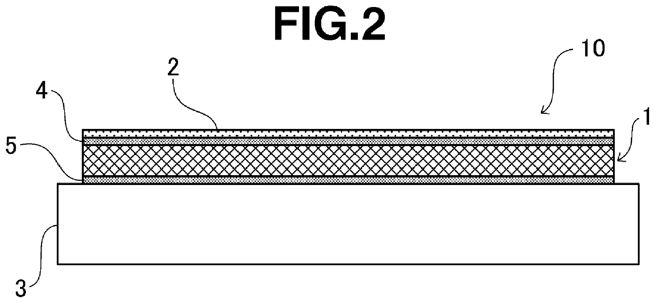

FIG. 2 illustrates a pellicle 10 comprising the pellicle frame 1 and a pellicle membrane 2 which is attached or bonded to the upper end surface of the pellicle frame 1 via a PSA or adhesive 4. Also, the lower end surface of the pellicle frame 1 is releasably attached or bonded to a photomask 3 via a PSA or adhesive 5, for protecting the patterned surface of the photomask 3.

The material of which the pellicle frame main body is made constitutes a substrate of the pellicle frame. While the material of the pellicle frame main body is not particularly limited, any well-known material may be used. Since the pellicle frame for the EUV lithography can be exposed to high temperature, a material having a low coefficient of thermal expansion is preferred. Exemplary materials include Si, SiO₂, SiN, quartz, Invar, titanium, titanium alloys, aluminum, and aluminum alloys. Inter alia, metals are preferred for ease of working and light weight, with a choice from titanium, titanium alloys, aluminum, and aluminum alloys being more preferred. In view of a low coefficient of thermal expansion, metals having a coefficient of linear expansion of up to 10×10⁻⁶ (1/K) are preferred, with a choice from titanium and titanium alloys being more preferred.

According to the invention, the insulating layer is formed on the surface of the pellicle frame main body, that is, any of the upper end surface, lower end surface, inside surface and outside surface of the pellicle frame main body. The material of the insulating layer should preferably have a volume resistivity of at least 10⁸ Ω·m, more preferably at least 10⁹ Ω·m, even more preferably at least 10¹⁰ Ω·m. From the standpoint of material availability, the upper limit of volume resistivity is preferably 10¹⁹ Ω·m or less. As long as the volume resistivity is at least 10⁸ Ω·m, the material of the insulating layer is not particularly limited and any of well-known material may be used. Examples include silicon-based inorganic coatings, elastomers, ceramics, and plastics. Since hydrogen radicals are present in an EUV exposure apparatus, inorganic materials which are resistant to hydrogen radicals are preferred, though not limitative. The volume resistivity of typical insulating materials is shown below, with the figure in parentheses indicating a volume resistivity.

Examples of the material of the insulating layer include organic and inorganic materials such as quartz glass (>10¹⁶ Ω·m), silicone rubber (10¹²-10¹³ Ω·m), alumina (10⁹-10¹² Ω·m), steatite (10¹¹-10¹³ Ω·m), paraffin (10¹³-10¹⁷ Ω·m), acrylic resin (>10¹³ Ω·m), epoxy resin (10¹²-10¹³ Ω·m), polyvinyl chloride (5×10¹²-10¹³ Ω·m), polytetrafluoroethylene or fluoro-resin (10¹⁵-10¹⁹ Ω·m), nylon (10⁸-10¹³ Ω·m), polyethylene (>10¹⁴ Ω·m), polystyrene (10¹⁵-10¹⁹ Ω·m), trifluoroethylene (1.2×10¹³ Ω·m), and polyimide (10¹²-10¹³ Ω·m).

In view of working, the insulating layer is preferably non-pressure-sensitive adhesive. As used herein, the term "non-pressure-sensitive adhesive" means that a material does not substantially possess pressure-sensitive adhesiveness.

The method for forming the insulating layer on the surface of a pellicle frame main body may be selected from well-known methods. In general, spray coating, electrostatic coating, electrodeposition, physical vapor deposition, and chemical vapor deposition are known.

The thickness of the insulating layer formed on the surface of a pellicle frame main body may be selected as appropriate depending on the material and method used. From the standpoints of productivity and workability, the insulating layer has a thickness of typically 0.01 to 500 µm, preferably 0.1 to 200 µm.

Before the insulating layer is formed on the surface of a pellicle frame main body, the pellicle frame main body may be previously subjected to surface treatment. Onto the surface of pellicle frame main body, any of cleaning, blasting, chemical polishing, electrolytic polishing, and anodization, for example, may be applied if necessary.

Also, the outside surface of the pellicle frame is typically provided with a jig hole which is utilized during handling or dismounting of the pellicle from the photomask. With respect to the size of the jig hole, the length of the jig hole in thickness direction of the pellicle frame (diameter in the case of a circular hole) is preferably 0.5 to 1.0 mm. While the shape of the jig hole is not particularly limited, it may be either circular or rectangular. The insulating layer may be formed either before or after the jig hole is perforated.

The pellicle frame may be provided with a ventilating port. The ventilating port may be provided with a filter for preventing contaminant ingress. The pellicle frame may also be provided with an outward or inward projection. When such a projection is used, the filter may be formed in the projection. When the outward projection is provided with a connection means (e.g., screw or PSA) to an exposure original, the PSA for the photomask may be omitted.

In the practice of the invention, the pellicle frame is provided on its upper end surface with a pellicle membrane via a PSA or adhesive. The material of PSA or adhesive is not limited and any well-known materials may be used. A PSA or adhesive having a strong bonding force is preferred for firmly holding the pellicle membrane.

Although the material of the pellicle membrane is not particularly limited, a material having a high transmittance at the wavelength of the exposure light source and high light resistance is preferred. For example, a very thin silicon membrane, silicon membrane, carbon membrane (e.g., graphene, diamond-like carbon, and carbon nanotubes) or the like is used in the EUV lithography. When it is difficult to handle the pellicle membrane alone, a pellicle membrane supported by a rim of silicon or the like may be used. In this case, a pellicle can be readily constructed by bonding the region of the rim to the pellicle frame.

Further, the pellicle frame is provided on its lower end surface with a photomask PSA for mounting the pellicle on the photomask. In general, the photomask-compatible PSA is preferably formed on the entire periphery of the pellicle frame.

As the photomask PSA, any of well-known agents may be used, for example, acrylic PSA, silicone base PSA, and rubber base PSA. The PSA may have been worked to any desired shape, if necessary.

To the lower end surface of the photomask PSA, a release layer or separator may be attached for protecting the PSA. While the material of the release layer is not particularly limited, use may be made of polyethylene terephthalate (PET), polytetrafluoroethylene (PTFE), tetrafluoroethylene-perfluoroalkyl vinyl ether copolymers (PFA), polyethylene (PE), polycarbonate (PC), polyvinyl chloride (PVC), and polypropylene (PP), for example. Also, if necessary, such release agents as silicone-based release agents and fluorochemical release agents may be coated on the surface of the release layer.

The pellicle of the invention may serve not only as a protective member for protecting an exposure original from particulate contamination in an EUV aligner, but also as a protective member for protecting an exposure original during its storage or transportation. In preparing a pellicle-mounted exposure original by mounting a pellicle on an exposure original, typically photomask, an electrostatic chucking method, mechanical securing method or the like may be used as well as the aforementioned method of bonding with the photomask PSA.

A further embodiment of the invention is a method for manufacturing a semiconductor device or LC display panel, which includes the step of exposing a substrate (semiconductor wafer or LC matrix) to radiation through the pellicle-mounted exposure original. For example, in the lithography step which is one of the steps of the process of manufacturing a semiconductor device or LC display panel, the stepper is installed with the pellicle-mounted exposure original and exposure is performed to form a photoresist pattern corresponding to an integrated circuit or the like on a substrate. In general, a projection optical system is used in the EUV lithography such that EUV radiation is reflected by the exposure original and directed to the substrate. The exposure step is performed under reduced pressure or vacuum. Even when contaminants deposit on the pellicle in the lithography step, the contaminants are out of focus on the photoresist-coated wafer, preventing the images of contaminants from causing short- or open-circuiting in the integrated circuit. Therefore, the yield of the lithography step can be improved by using the pellicle-mounted exposure original.

The optical aligners used in the fabrication of semiconductor devices or the like generally include a contact aligner, proximity aligner, mirror projection aligner, step-and-repeat projection aligner, and step-and-scan projection aligner. In the step-and-scan projection aligner, for example, since the circuit pattern is transferred onto a wafer by scanning the circuit pattern on the exposure original through a thin slit, the exposure original and the wafer are synchronously moved at the scanning speed corresponding to the magnifying power of the projection optical system. At this point, the pellicle mounted on the exposure original is similarly moved.

In an embodiment of the invention wherein the scanning speed is 300 mm/sec or higher, effective friction occurs between the pellicle and the ambient air so that the pellicle frame may be triboelectrically charged. When the scanning speed is low (or slow), it has no significant influence. When the scanning speed is high (or fast), however, it has a significant influence (typically vibration) on the pellicle, photomask, substrate, and components of the aligner, resulting in an increased frequency of generation of undesired contaminants. Therefore, the inventive pellicle becomes more effective as the scanning speed is higher, and can accommodate a scanning speed of 550 mm/sec or higher, and even an ultrahigh scanning speed of 700 mm/sec or higher. The upper limit of scanning speed, which is dependent on the performance of the aligner, is generally about 2,000 mm/sec.

The inventive pellicle, which is constructed so as to trap contaminants by electric charges, has an auxiliary effect of eliminating a filter which is otherwise attached to the pellicle. The number of components of the pellicle is thus reduced, leading to a cost reduction and productivity improvement. This becomes a great advantage when the pellicle is used in an EUV aligner where only a limited space is available for pellicle installation.

### EXAMPLES

Examples and Comparative Examples are given below for illustrating the invention, but the invention is not limited thereto.

### [Example 1]

There was furnished a pellicle frame main body (outer dimensions 150 mm × 118 mm × 1.5 mm (high), width 4.0 mm) of titanium. The pellicle frame main body was provided on its side surfaces with 12 ventilating ports (throughholes) of diameter 0.8 mm. The pellicle frame was washed with pure water, after which it was subjected to surface treatment by a sand blasting tool of blasting glass beads under a discharging pressure of 1.5 kg/cm² for 1 minute for thereby roughening the frame surface. Then the pellicle frame was immersed in an alkaline solution to etch its surface and then washed with water. After rinsing with pure water, an acrylic resin-based coating composition, Elecoat Frosty W-2 (Shimizu Co., Ltd.) was applied to the surface of the pellicle frame main body by anionic electrodeposition coating to form an insulating layer having a thickness of 5 µm. The pellicle frame was shower-rinsed with pure water and heat-treated in an oven at 200°C for 30 minutes.

The pellicle frame was washed with a neutral detergent and pure water. Then a material obtained by adding 1 part by weight of curing agent (PT-56 by Shin-Etsu Chemical Co., Ltd.) to 100 parts by weight of silicone resin base PSA (X-40-3264 by Shin-Etsu Chemical Co., Ltd.) and stirring was coated onto the upper end surface of the pellicle frame to form a PSA layer of 1 mm wide and 0.1 mm thick along the overall periphery. A photomask PSA obtained by adding 0.1 part by weight of curing agent (L-45 by Soken Chemical & Engineering Co., Ltd.) to 100 parts by weight of acrylic resin base PSA (SK-Dyne 1499M by Soken Chemical & Engineering Co., Ltd.) and stirring was coated onto the lower end surface of the pellicle frame to form a layer of 1 mm wide and 0.1 mm thick along the overall periphery. Thereafter, the pellicle frame was heated at 100°C for 12 hours to cure the PSA layers on the upper and lower end surfaces. Subsequently, a very thin silicon membrane as the pellicle membrane was compression bonded to the PSA layer on the upper end surface of the pellicle frame to complete a pellicle.

### [Example 2]

There was furnished a pellicle frame main body (outer dimensions 150 mm × 118 mm × 1.5 mm (high), width 4.0 mm) of titanium. The pellicle frame main body was provided on its side surfaces with 12 ventilating ports (throughholes) of diameter 0.8 mm. Using a vacuum evaporating chamber and gas species, monosilane and oxygen (i.e., SiH₄/O₂ mixture), vacuum evaporation was carried out under a pressure of 1 Pa to deposit a silicon dioxide (SiO₂) coating having a thickness of 10 µm as an insulating layer on the surface of the pellicle frame main body. As in Example 1 aside from using this pellicle frame, there was prepared a pellicle having a pellicle membrane on the upper end surface of the pellicle frame.

### [Example 3]

There was furnished a pellicle frame main body (outer dimensions 150 mm × 118 mm × 1.5 mm (high), width 4.0 mm) of titanium. The pellicle frame main body was provided on its side surfaces with 12 ventilating ports (throughholes) of diameter 0.8 mm. By using a vacuum evaporating chamber, evaporating aluminum and feeding oxygen gas, vacuum evaporation was carried out under a pressure of 1×10⁻² Pa to deposit an aluminum coating of 0.1 µm thick as an insulating layer on the surface of the pellicle frame main body. As in Example 1 aside from using this pellicle frame, there was prepared a pellicle having a pellicle membrane on the upper end surface of the pellicle frame.

### [Comparative Example 1]

A pellicle was completed as in Example 1 except that an acrylic resin coating was not applied to a pellicle frame main body of titanium.

### [Contamination test]

Before the pellicle frame and the pellicle membrane were assembled, the pellicle frames of Examples 1 to 3 and Comparative Example 1 were inspected for contamination by directing condensing light to the inner wall of the frame in a darkroom. The pellicle frame in which 5 to 10 contaminants were attached to its inner wall was selected. In a clean room of Class 1, a pellicle membrane free of contaminants was assembled with the pellicle frame to complete a pellicle. The pellicle was mounted on a quartz photomask of 6 inch square which had been thoroughly washed with neutral detergent and pure water.

Subsequently, the photomask-mounted pellicle was placed in a vacuum chamber where the pressure was reduced from atmospheric to 1 Pa over 5 minutes and then restored to atmospheric over 5 minutes. By directing condensing light to the pellicle membrane in a darkroom, it was inspected whether or not contaminants deposited on the pellicle membrane.

**[Table 1]**

| | Surface material | Volume resistivity (Ω·m) | Contamination test |
|---|---|---|---|
| Example 1 | acrylic resin | >10¹³ | Nil |
| Example 2 | SiO₂ | >10¹⁶ | Nil |
| Example 3 | alumina | 10⁹-10¹² | Nil |
| Comparative Example 1 | titanium | 5×10⁻³ | Found |

It is evident from the results in Table 1 that no contaminants were observed in Examples 1 to 3 whereas 3 contaminants were observed in Comparative Example 1. It is demonstrated that Examples within the scope of the invention provide pellicles which are effective for preventing contaminants from falling off the pellicle frame inner wall.

### REFERENCE SIGNS LIST

- 1: pellicle frame
- 1a: pellicle frame main body
- 1b: insulating layer
- 2: pellicle membrane
- 3: photomask
- 4: PSA or adhesive for pellicle membrane
- 5: PSA or adhesive for photomask
- 10: pellicle
- 11: inside surface of pellicle frame
- 12: outside surface of pellicle frame
- 13: upper end surface of pellicle frame
- 14: lower end surface of pellicle frame

## Claims

1. An pellicle frame in a frame shape comprising a pellicle frame main body and an insulating layer covering the pellicle frame main body.

2. The pellicle frame of claim 1 wherein the insulating layer has a volume resistivity of at least 10⁸ Q m.

3. The pellicle frame of claim 1 or 2 wherein the pellicle frame main body is made of titanium or a titanium alloy.

4. The pellicle frame of claim 1 or 2 wherein the insulating layer is non-pressure-sensitive adhesive.

5. The pellicle frame of claim 1 or 2 wherein the insulating layer is formed of an inorganic material.

6. The pellicle frame of claim 1 or 2 wherein the insulating layer is formed on the entire surface of the pellicle frame main body.

7. The pellicle frame of claim 1 or 2 wherein the pellicle frame is made of a metal having a coefficient of linear expansion of up to 10×10⁻⁶ (1/K).

8. The pellicle frame of claim 1 or 2 wherein the pellicle frame has a thickness of less than 2.5 mm.

9. A pellicle comprising the pellicle frame of claim 1 and a pellicle membrane which is disposed on the upper end surface of the pellicle frame via an adhesive or pressure-sensitive adhesive.

10. The pellicle of claim 9 which is used for exposure under vacuum or reduced pressure.

11. The pellicle of claim 9 or 10 which is used in EUV lithography.

12. The pellicle of claim 9 or 10 which is not equipped with a filter.

13. The pellicle of claim 9 or 10 which is used in exposure at a scanning speed of at least 300 mm/sec.

14. The pellicle of claim 9 or 10, having a height of up to 2.5 mm.

15. The pellicle of claim 9 or 10 wherein the pellicle membrane is a pellicle membrane held by a rim.

16. A pellicle-mounted exposure original comprising an exposure original and the pellicle of claim 9 mounted thereon.

17. The pellicle-mounted exposure original of claim 16 wherein the exposure original is an exposure original for EUV lithography.

18. The pellicle-mounted exposure original of claim 16 which is a pellicle-mounted exposure original for use in EUV lithography.

19. An exposure method comprising the step of exposure through the pellicle-mounted exposure original of claim 16.

20. A method for manufacturing a semiconductor device comprising the step of exposing a substrate to radiation through the pellicle-mounted exposure original of claim 16 under vacuum or reduced pressure.

21. A method for manufacturing a liquid crystal display panel comprising the step of exposing a substrate to radiation through the pellicle-mounted exposure original of claim 16 under vacuum or reduced pressure.

22. A method for manufacturing a semiconductor device comprising the step of exposing a substrate to EUV through the pellicle-mounted exposure original of claim 16.

23. A method for manufacturing a liquid crystal display panel comprising the step of exposing a substrate to EUV through the pellicle-mounted exposure original of claim 16.

24. A method for manufacturing a semiconductor device comprising the step of exposing a substrate to radiation through the pellicle-mounted exposure original of claim 16 at a scanning speed of at least 300 mm/sec.

25. A method for manufacturing a liquid crystal display panel comprising the step of exposing a substrate to radiation through the pellicle-mounted exposure original of claim 16 at a scanning speed of at least 300 mm/sec.
